# EUROPEAN PATENT APPLICATION

(11) **EP 1 775 320 A1**
(43) Date of publication of application: **18.04.2007**
(21) Application number: 05767102.6
(22) Date of filing: 28.07.2005
(51) Int. Cl.: C08L 23/20, C08J 5/18, H01C 17/02, H05K 3/46

(54) **POLY-4-METHYL-1-PENTENE RESIN COMPOSITION, FILM, AND MOLD FOR PRODUCING ELECTRONIC COMPONENT SEALING BODY**

(30) Priority: 03.08.2004 JP 2004227209
(71) Applicant: Mitsui Chemicals, Inc., Tokyo 105-7117 (JP)
(72) Inventor: TANAKA, Tooru, Mitsui Chemicals, Inc., Sodegaura-shi, Chiba 2990265 (JP); HIROSE, Toshiyuki, Mitsui Chemicals, Inc., Sodegaura-shi, Chiba 2990265 (JP)
(74) Representative: Cresswell, Thomas Anthony
(86) International application number: PCT/JP2005/013827
(87) International publication number: WO 2006/013774

(57) **Abstract**

[PROBLEMS]

To provide a resin composition that has a short semicrystallization time, and when molded into film, a film bears a high degree of surface crystallization and a small blocking coefficient. Further, to provide a release film having good releasability suitable for the production of a FPC, which is obtained by molding the resin composition. Further, to provide a mold for production of a sealed electronic element product having excellent heat resistance and releasibility, in which the mold is hard to deform even when repeatedly used in the production of a sealed electronic element product of an LED or the like, and to provide an LED mold.

[MEANS FOR SOLVING PROBLEMS]

The invention provides a poly 4-methyl-1-pentene resin composition which comprises a polymer containing 80% by mass or more of 4-methyl-1-pentene in which the resin composition has a melting point of 170 to 240°C and a semicrystallization time of 70 to 220 seconds, and a release film having good releasibility, a mold for production of a sealed electronic element product having excellent heat resistance and releasibility and an LED mold, which are obtained by molding the resin composition.

## Description

### TECHNICAL FIELD

The present invention relates to a poly 4-methyl-1-pentene resin composition having excellent releasability. More specifically, the invention relates to a poly 4-methyl-1-pentene resin composition that has a short semicrystallization time, and when molded into film, a film bears a high degree of surface crystallization, and thus has a small blocking coefficient in the film and excellent releasability, and to a mold for production of a sealed electronic element product, in particular, a mold for sealing a light emitting diode (hereinafter abbreviated to an "LED"), the so-called "LED mold" and to a release film suitable for the production of a flexible printed circuit board, which are obtained by molding the resin composition.

### BACKGROUND ART

There has been well known that as the degree of integration of IC increases with the rapid progress of electronic devices, a printed circuit board is widely used for meeting the demands for higher density and higher reliability. The printed circuit board includes a single-sided printed circuit board, a double-sided printed circuit board, a multilayer printed circuit board and a flexible printed circuit board. However, in particular, the scope of the applicable field of a multilayer flexible printed circuit board (hereinafter abbreviated to an "FPC") is extended in that an electrically insulating layer is placed between conductive layers consisting of three or more layers and it is integrated therewith, and therefore it is possible to connect any conductive layers together and connect between a lead of an electronic element mounted on the printed circuit board and any conductive layer. This FPC is produced by laminating a copper foil and a polyimide film with an adhesive.

By the way, copper clad laminates are fabricated prior to the production of the FPC by heat-pressure treating a prepreg placed on a copper foil to thereby integrate the copper foil and the prepreg. In this case, the copper clad laminates are not fabricated in pairs and plural copper clad laminates, each comprising a release film sandwiched therewith, are simultaneously press molded to each other and the release film is peeled off after press molding to obtain the copper clad laminates in pairs.

As the release film, a film comprising poly 4-methyl-1-pentene has been proposed to be used for its excellent heat resistance and releasibility after the heat-pressure treatment. Poly 4-methyl-1-pentene has excellent heat resistance and releasibility in molding of the copper clad laminates at about 170 to 180°C since it has high melting point of about 235°C.

However, in recent years, it has been strongly required to have a high quality FPC due to the increase in wiring speed and the improvement in reliability. Conditions of the heat-pressure treatment at the time of fabricating the copper clad laminates to be used for production of such print circuit board has also become severe and a release film is also required to further have excellent releasibility.

In addition, a sealed electronic element product in which an electronic device, for example, an LED, a transistor and an integrated circuit such as an LSI device, an IC device and a CCD device, a condenser, a resistor, a coil, a microswitch, a dip switch or the like is/are sealed, has been produced by placing electronic element(s) in a metal mold, injecting a sealing material composed of a thermosetting resin, for example, an epoxy resin, or the like into the mold and hardening it. However, there is a problem that the metal mold is expensive and hard to be produced in a large scale. In addition, there is a problem that a mold made of a resin such as polyphenylene sulfide (PPS) is likely to deform when the sealing material composed of a thermosetting resin is hardened.

Patent Document 1 discloses a method of producing 4-methyl-1-pentene copolymer having good transparency and an improved yield of a solvent-insoluble polymer, by polymerizing a 4-methyl-pentene-1 polymer in two-stages which differ in the content of an α-olefin. However, the degree of surface crystallization of a film composed of the copolymer is not sufficient, and hence there is a problem in releasability when it is used as a release film.

Further, Patent Document 2 discloses a technique that a thermoplastic norbornene resin is used as the mold for production of a sealed electronic element product in the production of a sealed electronic element product of an LED, a diode, a transistor, an integrated circuit such as an LSI device, an IC device and a CCD device using a thermosetting resin such as an epoxy resin as a sealing material. However, there is a problem in durability upon repeated use.
[Patent Document 1] JP-A No. 63-63707
[Patent Document 2] JP-A No. 6-114846
[Patent Document 3] JP-A No. 57-70653
[Patent Document 4] JP-A No. 56-138981

### DISCLOSURE OF THE INVENTION

### (Problems to be Solved by the Invention)

It is an object of the present invention to solve the above-mentioned problems, and thus to provide a resin composition that has a short semicrystallization time, and when molded into film, a film bears a high degree of surface crystallization and a small blocking coefficient. It is also an object of the invention to provide a release film having good releasability suitable for the production of a FPC, which is obtained by molding the resin composition. Further, it is an object of the invention to provide a mold for production of a sealed electronic element product having excellent heat resistance and releasibility, in which the mold is hard to deform when the sealing material composed of a thermosetting resin is hardened during the production of a sealed electronic element product of an LED or the like and is hard to deform even when repeatedly used, and to provide an LED mold.

### (Means to Solve the Problems)

The present inventors have studied extensively to solve the above-mentioned problems, and as a result, they have found that a resin composition, which comprises a specific amount of a polymer containing a specific amount of 4-methyl-1-pentene, has a short semicrystallization time, and a film obtained by molding the composition has a high degree of surface crystallization and a small blocking coefficient, thereby solving the above-mentioned problems, and thus have completed the invention.

That is, the present invention provides:
[1] a poly 4-methyl-1-pentene resin composition which comprises a polymer (A) containing 80% by mass or more of 4-methyl-1-pentene, wherein the resin composition has a melting point of 170 to 240°C and a semicrystallization time of 70 to 220 seconds;
[2] the poly 4-methyl-1-pentene resin composition as described in the above [1], which comprises 5 to 70% by mass of the polymer (A) containing 95 to 100% by mass of 4-methyl-1-pentene and 30 to 95% by mass of the polymer (B) containing 4-methyl-1-pentene and an olefin having 2 to 20 carbon atoms, other than 4-methyl-1-pentene;
[3] the poly 4-methyl-1-pentene resin composition as described in the above [2], wherein the polymer (A) is a homopolymer of 4-methyl-1-pentene;
[4] a film which is obtained by molding the poly 4-methyl-1-pentene resin composition as described in the above [1] to [3], wherein the film has a blocking coefficient of 4 to 10 gf/cm²;
[5] a film which is obtained by molding the poly 4-methyl-1-pentene resin composition as described in the above [1] to [3], wherein the film has a degree of surface crystallization of 15 to 60%;
[6] a release film which is the film as described in the above [4] or [5];
[7] a mold for production of a sealed electronic element product, which is obtained by molding the poly 4-methyl-1-pentene resin composition as described in the above [1] to [3]; and
[8] an LED mold which is obtained by molding the poly 4-methyl-1-pentene resin composition as described in the above [1] to [3].

### (Effects of the Invention)

A film comprising a poly 4-methyl-1-pentene resin composition of the invention has a short semicrystallization time, a high degree of surface crystallization and a small blocking coefficient, and thus is good in releasability and can be suitably used as a release film in the production of an FPC, or the like. Furthermore, the poly 4-methyl-1-pentene resin composition of the invention can be suitably used as a mold for production of a sealed electronic element product, particularly, an LED mold since it has excellent heat resistance and releasibility and it is hard to deform when a thermoplastic sealing material is hardened and hard to deform even when repeatedly used, and therefore, the industrial value is extremely high.

### BEST MODE FOR CARRYING OUT THE INVENTION

Hereinafter, a poly 4-methyl-1-pentene resin composition according to the present invention, and a film and a mold for production of a sealed electronic element product which are obtained by molding the resin composition will be described.

### [Polymer (A) of the invention]

The polymer (A) of the invention is a crystalline polymer containing 80% by mass or more of 4-methyl-1-pentene, which includes a polymer of 4-methyl-1-pentene and an olefin having 2 to 20 carbon atoms, other than 4-methyl-1-pentene, or a homopolymer of 4-methyl-1-pentene.

The polymer (A) of the invention is preferably a crystalline polymer mainly containing 80% by mass or more, preferably 90% by mass or more, more preferably 95 to 100% by mass and even more preferably 99 to 100% by mass of 4-methyl-1-pentene, and the polymer (A) is most preferably a homopolymer of 4-methyl-1-pentene.

The homopolymer of 4-methyl-1-pentene refers to the one that does not substantially have constituent units other than a repeating unit composed of 4 -methyl-1-pentene and does not positively copolymerize by adding a monomer other than 4-methyl-1-pentene, which is copolymerizable with 4-methyl-1-pentene. When the proportion of 4-methyl-1-pentene units in the polymer (A) is high, it is preferable in that a film having a fast semicrystallization speed, a high degree of surface crystallization of the film obtained by molding a poly 4-methyl-1-pentene resin composition comprising the polymer (A) and a low blocking coefficient can be obtained.

Furthermore, examples of the olefin having 2 to 20 carbon atoms, other than 4-methyl-1-pentene, which can be used in copolymerizing with 4-methyl-1-pentene, include ethylene, propylene, 1-butene, 1-hexene, 1-octene, 1-decene, 1-tetradecene, 1-octadecene and the like. These olefins may be used alone or in a combination of two or more. Among these olefins, 1-decene, 1-tetradecene and 1-octadecene are preferred because good copolymerizability with 4-methyl-1-pentene and good toughness can be obtained.

A production method of the polymer (A) of the invention is not particularly limited. The polymer can be produced using a well-known catalyst such as a Ziegler-Natta catalyst and a metallocene-based catalyst and its crystal structure may be either isotactic or syndiotactic. For example, as disclosed in JP-A No. 2003-105022, the polymer can be obtained as a powder by polymerizing 4-methyl-1-pentene alone or copolymerizing 4-methyl-1-pentene with the above-mentioned olefin in the presence of a catalyst.

Further, the polymer (A) of the invention has an intrinsic viscosity [η] of preferably 2.5 to 4 dl/g, more preferably 3 to 3.8 dl/g, as measured in accordance with ASTM J1601.

### [Polymer (B) of the invention]

The polymer (B) of the invention is a crystalline polymer containing 4-methyl-1-pentene, which includes a copolymer of 4-methyl-1-pentene and an olefin having 2 to 20 carbon atoms, other than 4-methyl-1-pentene, preferably an α-olefin having 7 to 20 carbon atoms, more preferably an α-olefin having 8 to 20 carbon atoms. Herein, examples of the olefin having 2 to 20 carbon atoms include ethylene, propylene, 1-butene, 1-hexene, 1-heptene, 1-octene, 1-decene, 1-dodecene, 1-tetradecene, 1-hexadecene, 1-heptadecene, 1-octadecene, 1-eicosene and the like, preferably 1-decene, 1-dodecene, 1-tetradecene, 1-hexadecene, 1-heptadecene and 1-octadecene. These olefins may be used alone or in a combination of two or more. Among these olefins, 1-decene, 1-dodecene or 1-tetradecene are preferred because of good stiffness and good elastic modulus. Further, the content of a repeating unit derived from 4-methyl-1-pentene is in the range of preferably 80% by mass or more, more preferably 90 to 98% by mass or more and even more preferably 93 to 98% by mass, and the content of a repeating unit derived from the olefin having 2 to 20 carbon atoms, other than 4-methyl-1-pentene, is preferably less than 20% by mass. When the composition of the polymer (B) of the invention is within the above-mentioned ranges, a film obtained by molding a poly 4-methyl-1-pentene resin composition comprising the polymer (B) is excellent in moldability and stiffness.

The polymer (B) of the invention can be produced using a well-known catalyst such as a Ziegler-Natta catalyst and a metallocene-based catalyst and its crystal structure may be either isotactic or syndiotactic. For example, as described in JP-A No. 2003-105022, the polymer can be obtained as a powder by copolymerizing 4-methyl-1-pentene with the above-mentioned olefin in the presence of a catalyst.

Further, the polymer (B) of the invention has an intrinsic viscosity [η] in the range of preferably 2.5 to 4 dl/g, more preferably 3 to 3.8 dl/g, as measured in accordance with ASTM J1601.

### [Poly 4-methyl-1-pentene resin composition]

The poly 4-methyl-1-pentene resin composition of the invention is preferably a resin composition comprising 5 to 70% by mass, preferably 5 to 50% by mass of the polymer (A) of the invention and 30 to 95% by mass, preferably 50 to 95% by mass of the polymer (B) of the invention. Herein, the total amount of the polymer (A) and the polymer (B) is 100 parts by mass.

When the content of poly 4-methyl-1-pentene resin composition is within the range of the above-mentioned composition, the resin composition has a semicrystallization time of 70 to 220 seconds, preferably 70 to 165 seconds, and a film obtained by molding the resin composition has a degree of surface crystallization of 15 to 60%, preferably 20 to 50% and a blocking coefficient of 4 to 10 gf/cm², preferably 4 to 7 gf/cm², and the resin composition having good releasibility and good film moldability can be obtained.

### [Production of poly 4-methyl-1-pentene resin composition]

The poly 4-methyl-1-pentene resin composition of the invention can be obtained as a polymer powder by carrying out a prepolymerization which polymerizes the polymer (A) of the invention using a well-known catalyst such as a Ziegler-Natta catalyst and a metallocene-based catalyst, and subsequently, carrying out a postpolymerization which polymerizes the polymer (B) of the invention in the presence of the catalyst used in the prepolymerization.

The proportion of the polymer (A) of the invention and the polymer (B) of the invention can be given by controlling the amount of the polymers obtained in the prepolymerization and the postpolymerization by the amount of a monomer supplied in the polymerization and the polymerization time.

The molecular mass of the resin composition can be controlled by the polymerization temperature or by adding hydrogen to the polymerization system. An intrinsic viscosity [η] as measured in accordance with ASTM J1601 is preferably 2.5 to 4 dl/g, more preferably 3 to 3.8 dl/g.

Furthermore, various additives well known, which are blended to polyolefin, such as a heat resistance stabilizer, a weather resistance stabilizer, a rust preventive agent, a copper damage-resistance stabilizer and an antistatic agent, can be added to the obtained polymer powder within such a range that does not impair the object of the invention, melt-kneaded with a single-screw extruder, a multi-screw extruder, a kneader or the like, and pelletized or pulverized to obtain as pellets or the pulverized product. When a melt flow rate (MFR), as determined in accordance with ASTM D1238, is in the range of 10 to 40 g/10 min, and preferably 20 to 30 g/10 min, the film has good moldability, which is preferred.

Further, the poly 4-methyl-1-pentene resin composition of the invention preferably contains, depending upon the type of the monomer used, 1 to 10% by mass, preferably 2 to 7% by mass of an olefin having 2 to 20 carbon atoms, other than 4-methyl-1-pentene, i.e., ethylene or an α-olefin having 3 to 20 carbon atoms.

Furthermore, the poly 4-methyl-1-pentene resin composition of the invention can also be produced by blending the polymer (A) of the invention and the polymer (B) of the invention which are obtained by separately polymerizing using a well-known catalyst such as a Ziegler-Natta catalyst and a metallocene-based catalyst, in the above-mentioned amount ratio of the invention, mixing them in a mixer or the like, such as a Banbury mixer and a Henschel mixer, melt-kneading them with a single-screw extruder, a multi-screw extruder, a kneader or the like, and pelletizing or pulverizing them.

### [Film obtained by molding resin composition of the invention]

The poly 4-methyl-1-pentene resin composition of the invention can be molded into a film by subjecting the poly 4-methyl-1-pentene resin composition to a well-known method such as press molding, extrusion molding, inflation molding or calendar molding and may be stretched during or after film molding. Further, the resin composition may be subjected to an annealing treatment at a temperature less than its melting point.

Furthermore, the thickness of the film which comprises the poly 4-methyl-1-pentene resin composition of the invention varies depending upon the applications required, but is preferably in the range of 5 to 1000 µm, more preferably 50 to 100 µm when used as a release film because it is excellent in the productivity of the film and pinholes are not generated during film molding. The film may be formed as a multilayer film with other resins and can be also formed as a multilayer film by a coextrusion molding method, an extrusion lamination method, a heat lamination method, a dry lamination method or the like.

The film obtained by molding the poly 4-methyl-1-pentene resin composition of the invention can be suitably used as a wrap film for food packaging, a medical bag protective film, a film for a liquid crystal display reflector or the like, other than the release film.

### [Release film]

The release film as a film comprising the poly 4-methyl-1-pentene resin composition of the invention can be suitably used for a release film for a printed circuit board, a release film for a thermosetting resin or the like. The release film as a film comprising the poly 4-methyl-1-pentene resin composition of the invention has a high degree of surface crystallization and a small blocking coefficient, and thus has good releasability. In particular, the film can be suitably used as a release film for the production of an FPC.

### [Mold for production of sealed electronic element product]

A sealed electronic element product in which an electronic device, for example, an LED, a transistor and an integrated circuit such as an LSI device, an IC device and a CCD device, a capacitor, a resistor, a coil, a microswitch, a dip switch or the like is/are sealed, has been produced by placing electronic element(s) in a metal mold, injecting a sealing material having a thermosetting property, for example, an epoxy resin, or the like into the mold and hardening it. However, there is a problem in that the metal mold is expensive and is hard to be produced in a large scale. The mold for production of a sealed electronic element product, comprising the poly 4-methyl-1-pentene resin composition of the invention, has excellent releasibility and high heat resistance and stiffness, and can be suitably used as the mold for production of a sealed electronic element product.

### [LED mold]

The LED mold, the so-called mold for sealing a light emitting diode refers to a mold used for sealing an LED, of the above-mentioned molds for production of a sealed electronic element product. The LED mold comprising the poly 4-methyl-1-pentene resin composition of the invention has high heat resistance and stiffness and excellent releasibility, and can be suitably used as an LED mold since the mold is hard to deform when the sealing material composed of a thermosetting resin is hardened and is excellent in durability upon repeated use.

### EXAMPLES

Hereafter, the present invention will be explained in detail with reference to Examples, but the invention is not limited to these Examples and the like. A method for preparing a sample used in Examples and Comparative Examples and a method for determining physical properties were shown below.

### [Melt flow rate]

Melt flow rate was measured in accordance with ASTM D1238 under the conditions of the load of 5.0 kg and the temperature of 260°C.

### [Intrinsic viscosity [η]]

Using a moving viscometer (Type VNR053U Model manufactured by Rigo Co., Ltd.), a specific viscosity ηₛₚ of a sample, which is obtained by dissolving 0.25 to 0.27 g of a resin in 25 ml of decalin, was measured at 135°C in accordance with ASTM J1601, and the concentration was extrapolated to 0 to determined the ratio of the specific viscosity to the concentration as the intrinsic viscosity [η].

### [Semicrystallization time]

A sheet was prepared by press forming a pellet. From this sheet was cut off a 10 mg sample. Using a differential scanning calorimeter (Model DSC-7 manufactured by Perkin Elmer Inc.), a crystallization curve was observed by heating the sample at 280°C for 10 minutes under a nitrogen atmosphere, followed by cooling to 220°C at a temperature decrease speed of 320°C/min and followed by maintaining at 220°C and then the time (t1/2 (seconds)) necessary to reach half of the integration value of an exothermic peak in the crystallization curve was measured.

### [Degree of surface crystallization]

A 50 µm-thick film was prepared by forming at a cylinder temperature of 310°C and a chill roll temperature of 20°C using a cast film molding machine equipped with a T die. The surface of this film was sliced extremely thinly using a razor to obtain a 1 µm-thick sample. The wide-angle X-ray diffraction measurements were performed on the sample to calculate the degree of crystallization. The wide-angle X-ray diffraction was measured in the following method. An X-ray used for measurements is generated by using RINT 2500 (manufactured by Rigaku Corporation) as an X-ray diffraction apparatus. A copper anticathode was used as a target. An X-ray taken from a point focus with an output power of 50 kV × 300 mA was irradiated on the sample, and the intensity of diffracted X-rays was measured with a scintillation counter. 2θ scanning was performed in the range of 5 to 35° and wide-angle X-ray diffraction profiles of the sample were obtained. In addition, the same amorphous material as the sample was prepared and X-ray diffraction profiles of a real sample were divided into an amorphous halo and a crystal peak using X-ray diffraction profiles (amorphous halo) of the amorphous material, which are obtained by carrying out the same measurements. The degree of crystallization of the real sample was obtained as follows. First, a baseline was separated and the ratio of the total crystal peak areas to the total area was obtained in percentage.

### [Blocking coefficient]

A 50 µm-thick film was prepared by forming at a cylinder temperature of 310°C and a chill roll temperature of 20°C using a cast film molding machine equipped with a T die. From this film, two sheets of film were cut off (each 6 cm × 12 cm). The films were superimposed on each other, sandwiched between two sheets of metal plate which were subjected to a mirror surface treatment, heated and pressurized under the load of 5 MPa at 180°C for 30 minutes, and then cooled to room temperature. In accordance with ASTM D1893-67, the blocking coefficient (gf/cm²) was determined by measuring the maximum load upon shear peeling under the conditions of a testing speed of 200 mm/min, a load of 200 g and 180° peeling, using a universal material testing machine manufactured by Intesco Co., Ltd.

### [Peeling properties from copper foil]

A 50 µm-thick film was prepared by forming at a cylinder temperature of 310°C and a chill roll temperature of 20°C using a cast film molding machine equipped with a T die. From this film, a film was cut off (6 cm × 12 cm). The film and the copper foil were superimposed on each other, sandwiched between two sheets of metal plate which were subjected to a mirror surface treatment, heated and pressurized under the load of 5 MPa at 180°C for 30 minutes, and subsequently cooled to room temperature. Then, in accordance with ASTM D1893-67, peeling properties when the film was peeled off from the copper foil by taking the end of the film by hand were evaluated by the following criteria:
○: Easily peelable
Δ: Heaviness is felt upon peeling
×: Peeling is difficult

### [Peeling properties from epoxy resin]

A 50 µm-thick film was prepared by forming at a cylinder temperature of 310°C and a chill roll temperature of 20°C using a cast film molding machine equipped with a T die. From this film, a film was cut off (6 cm × 12 cm). The film and the sheet made of an epoxy resin were superimposed on each other, sandwiched between two sheets of metal plate which were subjected to a mirror surface treatment, heated and pressurized under the load of 5 MPa at 180°C for 30 minutes, and subsequently cooled to room temperature. Then, in accordance with ASTM D1893-67, peeling properties when the film was peeled off from the copper foil by taking the end of the film by hand were evaluated by the following criteria:
O: Having no stickiness onto epoxy resin and easily peelable
Δ: Stickiness is slightly felt and heaviness is felt upon peeling
×: Stickiness is significantly felt and impossible to peel by hand

### [Peeling properties from polyimide resin]

A 50 µm-thick film was prepared by forming at a cylinder temperature of 310°C and a chill roll temperature of 20°C using a cast film molding machine equipped with a T die. From this film, a film was cut off (6 cm × 12 cm). The film and the sheet made of a polyimide resin were superimposed on each other, sandwiched between two sheets of metal plate which were subjected to a mirror surface treatment, heated and pressurized under the load of 5 MPa at 180°C for 30 minutes, and subsequently cooled to room temperature. Then, in accordance with ASTM D1893-67, peeling properties when the film was peeled off from the copper foil by taking the end of the film by hand were evaluated by the following criteria:
O: Having no stickiness onto polyimide resin and easily peelable
Δ: Stickiness is slightly felt and heaviness is felt upon peeling
×: Stickiness is significantly felt and impossible to peel by hand

### [Example 1]

### (Preparation of solid catalyst component)

750 g of anhydrous magnesium chloride, 2,800 g of decane and 3,080 g of 2-ethylhexyl alcohol were reacted under heating at 130°C for 3 hours to give a homogeneous solution. Then, to the solution was added 220 ml of 2-isobutyl-2-isopropyl-1,3-dimethoxypropane, and the mixture was stirred at 100°C for 1 hour. The homogeneous solution thus obtained was cooled to room temperature and the total amount of 3000 ml of the homogeneous solution was added dropwise to 800 ml of titanium tetrachloride, which was kept at -20°C, under stirring over a period of 45 minutes. After completion of the dropwise addition, the temperature of the resulting mixture was elevated to 110°C over a period of 4.5 hours. When the temperature reached 110°C, to the mixture was added 5.2 ml of 2-isobutyl-2-isopropyl-1,3-dimethoxypropane, which was then stirred for 2 hours at the same temperature. After completion of the 2-hour reaction, the mixture was hot filtered to separate a solid. The solid was resuspended in 1000 ml of titanium tetrachloride, and the resulting suspension was again heated at 110°C for 2 hours to carry out a reaction. After completion of the reaction, the mixture was again hot filtered to separate a solid. The solid was thoroughly washed with decane and hexane at 90°C until no free titanium compound was detected in the wash liquid. The solid titanium catalyst component prepared by the above process was stored as a decane slurry, but a part thereof was dried for the purpose of examining the catalyst composition. The solid titanium catalyst component thus obtained had a composition comprising 3.0% by mass of titanium, 17.0% by mass of magnesium, 57% by mass of chlorine, 18.8% by mass of 2-isobutyl-2-isopropyl-1,3-dimethoxypropane and 1.3% by mass of 2-ethylhexyl alcohol.

### (Preparation of polymer (A))

To a SUS polymerization tank with a capacity of 150 L equipped with a stirrer, 100 L of decane, 5.4 kg of 4-methyl-1-pentene, 6.75 L of hydrogen, 67.5 mmol of triethylaluminum and 0.27 mol (in terms of titanium atom) of the above-mentioned solid titanium catalyst component were added under a nitrogen atmosphere. The temperature of the polymerization tank inside was elevated to 60°C, prepolymerization was carried out for 3 hours with maintaining the temperature. After completion of the prepolymerization, a part of the resulting polymer slurry was sampled, and its slurry concentration was measured to obtain the amount of the polymer prepared in the prepolymerization. The polymer had the yield of 5.2 kg and the intrinsic viscosity [η] of 3.5 dl/g.

### (Preparation of polymer (B))

To the polymer slurry to which the above-mentioned preploymerization was carried out, were added 21.6 kg of 4-methyl-1-pentene and 710 g of decene-1. The temperature of the polymerization tank inside was maintained at 60°C, and postpolymerization of 4-methyl-1-pentene and decene-1 was carried out for 5 hours. The powders were taken out of the polymerization tank, filtered and washed, and then dried to obtain a powdery polymer. The resulting polymer had the yield of 26 kg and the intrinsic viscosity [η] of 3.5 dl/g. The mass ratio of the polymer prepared in the prepolymerization to the polymer prepared in the postpolymerization, i.e., the mass ratio of the polymer (A) to the polymer (B) was polymer (A)/polymer (B) = 20/80. Further, the decene-1 content in the polymer (B) obtained from the decene-1 content in the resin composition, which was determined by NMR measurements, and the mass ratio of the polymer prepared in the prepolymerization to the polymer prepared in the postpolymerization was 3.3% by mass.

### (Preparation of film)

A conventionally known neutralizing agent and a phenolic antioxidant were added to the resulting powdery polymer by carrying out the preploymerization and the postpolymerization, mixed in a Henschel mixer and melt-kneaded using an extruder at 290°C to obtain pellets of a poly 4-methyl-1-pentene resin composition. The resulting pellets had a melt flow rate of 25 g/10 min. Subsequently, a 50 µm-thick cast film was prepared by forming at a cylinder temperature of 310°C and a chill roll temperature of 20°C using a cast film molding machine equipped with a T die. The results of the evaluation of physical properties of the resulting film are shown in Table 1.

### [Example 2]

Polymerization was carried out in the same manner as in Example 1, except that the preparation of the polymer in the prepolymerization and the postpolymerization was controlled such that the mass ratio of the polymer (A) to the polymer (B) was polymer (A)/polymer (B) = 5/95. The powders obtained were melt-kneaded to obtain pellets. The resulting pellets had a MFR of 25 g/10 min. Subsequently, the pellets were subjected to film formation. The results of the evaluation of physical properties of the resulting film are shown in Table 1.

### [Example 3]

Polymerization was carried out in the same manner as in Example 1, except that the preparation of the polymer in the prepolymerization and the postpolymerization was controlled such that the mass ratio of the polymer (A) to the polymer (B) was polymer (A)/polymer (B) = 50/50. The resulting powders were melt-kneaded to obtain pellets. The pellets obtained had a MFR of 25 g/10 min. Subsequently, the pellets were subjected to film formation. The results of the evaluation of physical properties of the resulting film are shown in Table 1.

### [Comparative Example 1]

A powdery polymer (B) was obtained by performing only the postpolymerization of 4-methyl-1-pentene and decene-1 using a solid titanium catalyst component obtained in the same manner as in Example 1. Film formation was carried out in the same manner as in Example 1, except that the pellets (MFR of 26 g/10 min and decene-1 content of 3.3% by mass) of a polymer comprising 4-methyl-1-pentene and decene-1, which were obtained by melt-kneading the polymer (B), were used. The results of the evaluation of physical properties of the resulting film are shown in Table 1.

### [Comparative Example 2]

A powdery polymer (A) was obtained by performing only the prepolymerization of 4-methyl-1-pentene using a solid titanium catalyst component obtained in the same manner as in Example 1. Film formation was carried out in the same manner as in Example 1, except that the pellets (MFR of 24 g/10 min) of a homopolymer of 4-methyl-1-pentene, which were obtained by melt-kneading the polymer (A), were used. The results of the evaluation of physical properties of the resulting film are shown in Table 1.

### [Example 4]

### (Preparation of polymer (A))

A powdery homopolymer (A) of 4-methyl-1-pentene (intrinsic viscosity [η] of 3.4 dl/g) was obtained by performing only the prepolymerization of 4-methyl-1-pentene using a solid titanium catalyst component obtained in the same manner as in Example 1.

### (Preparation of polymer (B))

A powdery polymer (B) comprising 4-methyl-1-pentene and decene-1 (intrinsic viscosity [η] of 3.5 dl/g and decene-1 content of 3.3% by mass) was obtained by performing only the postpolymerization of 4-methyl-1-pentene and decene-1 using a solid titanium catalyst component obtained in the same manner as in Example 1.

### (Preparation of film)

10% by mass of the polymer (A) and 90% by mass of the polymer (B) that were obtained separately by polymerization, a conventionally known neutralizing agent and a phenolic antioxidant were mixed in a Henschel mixer and melt-kneaded using an extruder at 290°C to obtain pellets of a poly 4-methyl-1-pentene resin composition. The resulting pellets had an MFR of 25 g/10 min.

Subsequently, a 50 µm-thick cast film was formed at a cylinder temperature of 310°C and a chill roll temperature of 20°C using a cast film molding machine equipped with a T die. The results of the evaluation of physical properties of the resulting film are shown in Table 2.

### [Example 5]

Pellets were obtained in the same manner as in Example 4, except that 30% by mass of the polymer (A) and 70% by mass of the polymer (B) were used. The pellets obtained had an MFR of 25 g/10 min. Subsequently, the pellets were subjected to film formation. The results of the evaluation of physical properties of the resulting film are shown in Table 2.

### [Example 6]

Pellets were obtained in the same manner as in Example 4, except that 50% by mass of the polymer (A) and 50% by mass of the polymer (B) were used. The pellets obtained had an MFR of 25 g/10 min. Subsequently, the pellets were subjected to film formation. The results of the evaluation of physical properties of the resulting film obtained are shown in Table 2.

### [Example 7]

Pellets were obtained in the same manner as in Example 4, except that 70% by mass of the polymer (A) and 30% by mass of the polymer (B) were used. The pellets obtained had an MFR of 25 g/10 min. Subsequently, the pellets were subjected to film formation. The results of the evaluation of physical properties of the resulting film are shown in Table 2.

### [Example 8]

### (Preparation of polymer (A))

To a SUS polymerization tank with a capacity of 150 L equipped with a stirrer, 100 L of decane, 26 kg of 4-methyl-1-pentene, 230 g of decene-1, 6.75 L of hydrogen, 67.5 mmol of triethylaluminum and 0.27 mol (in terms of titanium atom) of the solid titanium catalyst component obtained in Example 1 were added under a nitrogen atmosphere. The temperature of the polymerization tank inside was maintained at 60°C, and polymerization of 4-methyl-1-pentene and decene-1 was carried out for 5 hours. The powders were taken out of the polymerization tank, filtered and washed, and then dried to obtain a powdery polymer (A). The resulting polymer powders had the yield of 26 kg and the intrinsic viscosity [η] of 3.5 dl/g. Further, the content of decene-1 in the resin composition, as determined by NMR measurements, was 1.0% by mass.

### (Preparation of polymer (B))

A powdery polymer (B) comprising 4-methyl-1-pentene and decene-1 (intrinsic viscosity [η] of 3.5 dl/g and decene-1 content of 3.3% by mass) was obtained using a solid titanium catalyst component obtained in the same manner as in Example 1.

### (Preparation of film)

30% by mass of the polymer (A) and 70% by mass of the polymer (B) which are obtained by the above-mentioned polymerization, a conventionally known neutralizing agent and a phenolic antioxidant were mixed in a Henschel mixer and melt-kneaded using an extruder at 290°C to obtain pellets. The resulting pellets had an MFR of 25 g/10 min.

Subsequently, a 50 µm-thick cast film was formed at a cylinder temperature of 310°C and a chill roll temperature of 20°C using a cast film molding machine equipped with a T die. The results of the evaluation of physical properties of the resulting film are shown in Table 2.

**[Table 1]**

| | Unit | Ex. 1 | Ex. 2 | Ex. 3 | Comp. Ex. 1 | Comp. Ex. 2 |
|---|---|---|---|---|---|---|
| Polymer (A) | % by mass | 20 | 5 | 50 | --- | 100 |
| Polymer (B) | % by mass | 80 | 95 | 50 | 100 | --- |
| Degree of surface crystallization | % | 31 | 19 | 39 | 15 | 47 |
| Semicrystallization time | sec | 120 | 213 | 79 | 251 | 57 |
| Blocking coefficient | gf/cm² | 7 | 9.3 | 5.5 | 10.5 | 3.3 |
| Film formation properties | --- | O | O | O | O | × |
| Peeling properties from copper foil | --- | O | O | O | Δ | Δ |
| Peeling properties from epoxy resin | --- | O | O | O | Δ | Δ |
| Peeling properties from polyimide resin | --- | O | O | O | Δ | Δ |

**[Table 2]**

| | Unit | Ex. 4 | Ex. 5 | Ex. 6 | Ex. 7 | Ex. 8 |
|---|---|---|---|---|---|---|
| Polymer (A) | % by mass | 10 | 30 | 50 | 70 | 30 |
| Polymer (B) | % by mass | 90 | 70 | 50 | 30 | 70 |
| Degree of surface crystallization | % | 25 | 30 | 39 | 43 | 27 |
| Semicrystallization time | sec | 161 | 93 | 82 | 71 | 140 |
| Blocking coefficient | gf/cm² | 9.1 | 6.2 | 5.3 | 4.6 | 7.5 |
| Film formation properties | --- | O | O | O | O | O |
| Peeling properties from copper foil | --- | O | O | O | O | O |
| Peeling properties from epoxy resin | --- | O | O | O | O | O |
| Peeling properties from polyimide resin | --- | O | O | O | O | O |

### INDUSTRIAL APPLICABILITY

A film obtained by molding a poly 4-methyl-1-pentene resin composition of the present invention has a high degree of surface crystallization and a small blocking coefficient, and thus has excellent releasability, and can be suitably used for the production of a printed circuit board, particularly, a multilayer flexible printed circuit board.

A mold for production of a sealed electronic element product obtained by molding a poly 4-methyl-1-pente resin composition of the present invention has excellent releasibility and high heat resistance and stiffness, and can be particularly suitably used as an LED mold since the mold is hard to deform when the sealing material composed of a thermosetting resin is hardened and is excellent in durability upon repeated use.

## Claims

1. A poly 4-methyl-1-pente resin composition which comprises a polymer (A) containing 80% by mass or more of 4-methyl-1-pentene, wherein the resin composition has a melting point of 170 to 240°C and a semicrystallization time of 70 to 220 seconds.

2. The poly 4-methyl-1-pentene resin composition according to claim 1, which comprises 5 to 70% by mass of the polymer (A) containing 95 to 100% by mass of 4-methyl-1-pentene and 30 to 95% by mass of the polymer (B) containing 4-methyl-1-pente and an olefin having 2 to 20 carbon atoms, other than 4-methyl-1-pentene.

3. The poly 4-methyl-1-pentene resin composition according to claim 2, wherein the polymer (A) is a homopolymer of 4-methyl-1-pentene.

4. A film which is obtained by molding the poly 4-methyl-1-pentene resin composition according to claims 1 to 3, wherein the film has a blocking coefficient of 4 to 10 gf/cm².

5. A film which is obtained by molding the poly 4-methyl-1-pentene resin composition according to claims 1 to 3, wherein the film has a degree of surface crystallization of 15 to 60%.

6. A release film which is the film according to claim 4 or 5.

7. A mold for production of a sealed electronic element product, which is obtained by molding the poly 4-methyl-1-pentene resin composition according to claims 1 to 3.

8. An LED mold which is obtained by molding the poly 4-methyl-1-pentene resin composition according to claims 1 to 3.
